# FASCICULE DE BREVET EUROPEEN

(11) **EP 2 513 992 B1**
(45) Date de publication et mention de la délivrance du brevet: **02.10.2013**
(21) Numéro de dépôt: 10807616.7
(22) Date de dépôt: 17.12.2010
(51) Int. Cl.: H02N 2/18, H01L 41/113

(54) **GENERATEUR ELECTRIQUE A RECUPERATION D'ENERGIE DE VIBRATIONS MECANIQUES**
ELEKTRISCHER GENERATOR MIT ENERGIERÜCKGEWINNUNG AUS MECHANISCHER VIBRATION
ELECTRICITY GENERATOR HAVING RECOVERY OF ENERGY FROM MECHANICAL VIBRATIONS

(30) Priorité: 17.12.2009 FR 0959097
(43) Date de publication de la demande: 24.10.2012
(73) Titulaire: Université de Savoie, 73011 Chambery Cedex (FR)
(72) Inventeur: FORMOSA, Fabien, F-74650 Chavanod (FR)
(74) Mandataire: Thibon, Laurent
(86) Numéro de dépôt international: PCT/FR2010/052789
(87) Numéro de publication internationale: WO 2011/073591

(56) Documents cités:
- WO-A1-02/061857
- WO-A1-2008/099437
- WO-A2-2005/036728
- WO-A2-2007/038157
- WO-A2-2008/005113
- DE-A1-102007 022 430

## Description

### Domaine de l'invention

La présente invention concerne un générateur adapté à produire de l'électricité à partir de vibrations mécaniques. Elle vise notamment la production d'électricité par récupération de l'énergie mécanique de vibration produite par certains équipements, par exemple des gaines de climatisation d'un bâtiment, des ordinateurs en fonctionnement, des machines industrielles, etc.

### Exposé de l'art antérieur

Pour alimenter certains systèmes électroniques à faible consommation, par exemple des capteurs de présence ou de température dans un bâtiment, on a proposé d'utiliser des générateurs adaptés à convertir l'énergie mécanique des vibrations de l'environnement en énergie électrique. Ceci permet notamment de réaliser des capteurs sans fils totalement autonomes, donc plus faciles à mettre en place, et ne nécessitant pas des opérations récurrentes et coûteuses de remplacement de batteries. Plus généralement, la récupération d'une énergie de vibration, présente des avantages évidents d'ordre pratique, économique, et écologique.

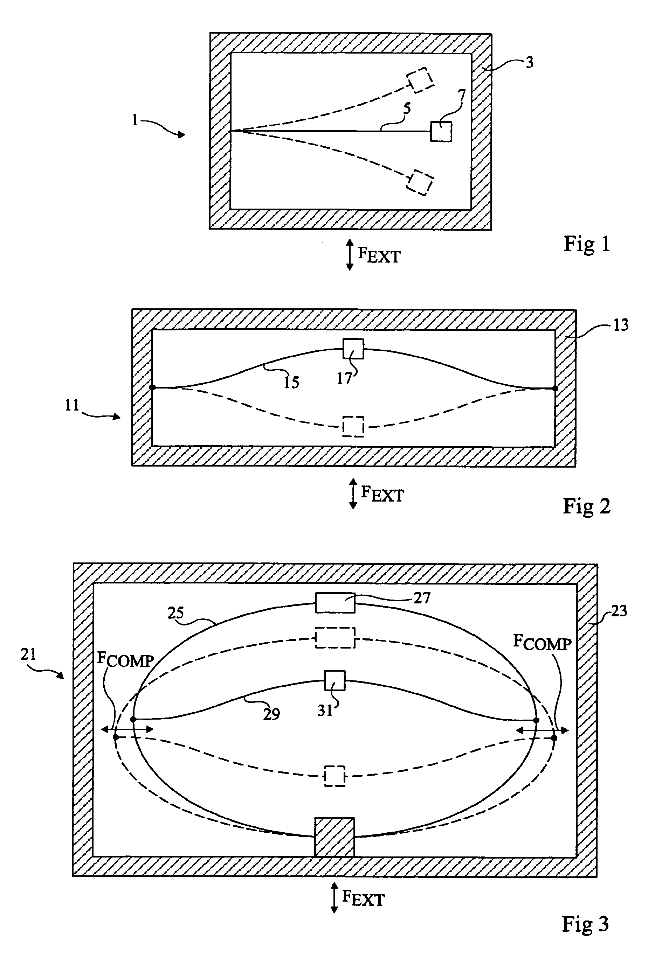

La figure 1 est une vue de côté très schématique illustrant le principe de fonctionnement d'un générateur électrique 1 à récupération d'énergie mécanique de vibration, de type monostable.

Le générateur 1 comprend un boîtier de support et de protection 3, de forme générale parallélépipédique, adapté à être monté sur une surface vibrante. Dans cet exemple, les vibrations extérieures sont susceptibles d'exercer, sur le boîtier 3, une excitation dont l'effet peut être représenté schématiquement par une force d'orientation F_{EXT}, sensiblement orthogonale à la face inférieure du boîtier. Le boîtier 3 contient une lame ressort 5, fixée par l'une de ses extrémités à une face latérale du boîtier, et dont l'autre extrémité est laissée libre. Dans une position de repos, la lame 5 est sensiblement orthogonale à l'orientation F_{EXT} de l'excitation extérieure. Une masse 7 est fixée à la lame 5, du côté de son extrémité libre, de façon à former un système oscillant monostable de type masse-ressort.

Sous l'effet des vibrations mécaniques extérieures, transmises par le boîtier 3, la lame 5 et la masse 7 oscillent de bas en haut autour d'une position d'équilibre. Sur la figure, la position d'équilibre est représentée en traits pleins et le mouvement des oscillations est illustré par des traits en pointillés.

Un convertisseur mécano-électrique, non représenté, est prévu pour convertir le mouvement de la lame 5 et/ou de la masse 7, en énergie électrique. Il peut s'agir d'un convertisseur de type piézoélectrique.

Un inconvénient d'un tel dispositif de récupération d'énergie est qu'il ne présente un bon rendement que lorsque la fréquence des vibrations extérieures correspond à la fréquence de résonance du système oscillant formé par la masse 7 et la lame 5. Or, le spectre des fréquences de vibration présentes dans l'environnement est généralement assez large et peut être variable. Ainsi, le générateur 1 ne récupère qu'une petite fraction de l'énergie mécanique des vibrations de l'environnement.

De plus, les fréquences de vibration couramment présentes dans l'environnement sont généralement assez basses, c'est-à-dire qu'elles ne dépassent pas quelques dizaines à quelques centaines de Hz. Or, la tendance actuelle vers la miniaturisation des dispositifs électroniques conduit à réduire les dimensions du générateur 1, et notamment les dimensions du système oscillant formé par la lame 5 et la masse 7. Il en résulte inévitablement une augmentation de la fréquence de résonance du système oscillant. Ainsi, un tel dispositif de récupération d'énergie présente un mauvais rendement de conversion mécano-électrique.

La figure 2 est une vue de côté très schématique illustrant le principe de fonctionnement d'un générateur électrique 11 de récupération d'énergie mécanique de vibration, de type bistable.

Comme le générateur 1 de la figure 1, le générateur 11 comprend un boîtier 13 susceptible d'être excité par des vibrations extérieures représentées par une force d'orientation F_{EXT}, orthogonale à la face inférieure du boîtier. Le boîtier 13 contient une lame ressort 15 dont les deux extrémités s'appuient, en compression, sur deux faces latérales opposées du boîtier. Les deux points d'appui de la lame 15 sur le boîtier 13 sont placés selon un axe sensiblement orthogonal à l'orientation F_{EXT} des vibrations. Une masse 17 est fixée à la lame 15, sensiblement en son milieu. La lame 15, en compression entre ses deux extrémités, et la masse 17, définissent un système non linéaire, ou bistable, qui peut, sous l'effet des vibrations extérieures, passer de l'une à l'autre de deux positions d'équilibre stable (représentées respectivement en trait plein et en traits pointillés sur la figure). Ce système peut également osciller autour de chacune des deux positions d'équilibre.

Un convertisseur mécano-électrique, non représenté, est prévu pour convertir les mouvements en énergie électrique.

Les sauts de l'une à l'autre des positions d'équilibre sont directement liés à la quantité d'énergie mécanique de vibration transmise par le boîtier, et non pas à la fréquence des vibrations. Ces sauts ne se produisent donc pas nécessairement de façon périodique.

Ainsi, le générateur 11, de type bistable, présente l'avantage, par rapport au générateur 1 de la figure 1, de type monostable, d'exploiter plus largement le spectre des fréquences de vibration de l'environnement.

Toutefois, le niveau d'énergie des vibrations extérieures doit être suffisant pour déclencher, le plus souvent possible, des sauts d'une position d'équilibre à l'autre. En deçà d'un certain niveau d'énergie de vibration, ces sauts ne se produisent plus. Dans ce cas, la production d'électricité est uniquement liée aux oscillations autour de l'une des deux positions d'équilibre, et seule la fraction d'énergie de vibration correspondant à la fréquence de résonance du dispositif est récupérée. Le rendement du générateur 11 est alors beaucoup moins bon.

Des générateurs connus sont décrits par WO 2008/005113 A2, WO 02/061857 A2 ou WO 2005/036728 A2.

### Résumé

Ainsi, un objet d'un mode de réalisation de la présente invention est de prévoir un générateur électrique à récupération d'énergie mécanique de vibration palliant au moins en partie les inconvénients des générateurs actuels.

Un objet d'un mode de réalisation de la présente invention est de prévoir un tel générateur présentant un rendement supérieur au rendement des générateurs actuels.

Un objet d'un mode de réalisation de la présente invention est de prévoir un tel générateur adapté à fonctionner à partir d'une large plage de fréquences de vibration.

Un objet d'un mode de réalisation de la présente invention est de prévoir un tel générateur dont le rendement reste bon même lorsque le niveau d'énergie des vibrations est faible.

Ainsi, un mode de réalisation de la présente invention prévoit un générateur électrique à récupération d'énergie mécanique de vibration, comprenant : un système bistable susceptible de prendre l'une ou l'autre de deux positions stables par rapport à deux extrémités, en réponse à une excitation d'une orientation donnée ; au moins un système oscillant monostable susceptible d'agir de façon périodique sur une au moins des deux extrémités, en réponse à ladite excitation ; et un convertisseur du mouvement d'un élément du système bistable en énergie électrique.

Selon un mode de réalisation de la présente invention, le système oscillant monostable comprend : une première lame ressort en anneau, fixée en un premier point à un support ; et une première masse, fixée à la première lame en un second point de l'anneau opposé au premier point, l'axe formé par les premier et second points étant non-orthogonal à ladite orientation ; et le système bistable comprend : une seconde lame ressort, en compression entre deux points de l'anneau formant lesdites extrémités, lesdites extrémités appartenant à une corde de l'anneau non-parallèle à ladite orientation ; et une seconde masse fixée à la seconde lame.

Selon un mode de réalisation de la présente invention, le convertisseur comprend au moins un élément piézoélectrique disposé sur la seconde lame.

Selon un mode de réalisation de la présente invention, le générateur comprend une pluralité de systèmes bistables disposés de façon que le système monostable soit susceptible d'agir simultanément sur chacun des systèmes bistables.

Selon un mode de réalisation de la présente invention, le système oscillant monostable comprend : des première et deuxième lames ressort en arc, en regard l'une de l'autre, chaque lame étant fixée par ses extrémités à un boîtier de support rigide, les points de fixation de chaque lame étant disposés selon une ligne non orthogonale à ladite orientation ; et des première et deuxième masses, chaque masse étant fixée à un point intermédiaire de l'une des lames via une liaison rigide non parallèle à ladite orientation ; et le système bistable comprend : une troisième lame ressort en compression entre les première et deuxième lames, les points d'appui de la troisième lame sur les première et seconde lames formant lesdites extrémités, ces points d'appui étant disposés selon une ligne non parallèle à ladite orientation ; et une troisième masse, fixée à la troisième lame.

Selon un mode de réalisation de la présente invention, le convertisseur comprend au moins un élément piézoélectrique disposé sur ladite troisième lame.

Selon un mode de réalisation de la présente invention, le système bistable comprend : une poutre à section cruciforme dont les terminaisons forment lesdites extrémités, la poutre étant fixée à un support par une première terminaison, et étant disposée parallèlement à ladite orientation ; et un système à ressort pour maintenir la poutre en compression entre ses terminaisons de façon qu'elle soit susceptible de prendre l'une ou l'autre de deux positions stables correspondant à la déformation de la poutre par flambage selon l'un ou l'autre de deux sens de rotation opposés ; et le système oscillant monostable comprend, du côté d'une seconde terminaison de la poutre, au moins une masse susceptible d'agir sur le système à ressort, en réponse à ladite excitation.

Selon un mode de réalisation de la présente invention, le système à ressort comprend une âme élastique traversant la poutre de part en part dans sa longueur, cette âme étant fixée, en tension, à chacune des terminaisons de la poutre.

Selon un mode de réalisation de la présente invention, ladite masse est reliée à la seconde terminaison de la poutre par l'intermédiaire d'un bras rigide orthogonal à ladite orientation.

Selon un mode de réalisation de la présente invention, le convertisseur comprend au moins un élément piézoélectrique disposé sur la poutre.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, est une vue de côté très schématique d'un générateur électrique à récupération d'énergie mécanique de vibration, de type monostable ;
la figure 2, précédemment décrite, est une vue de côté très schématique d'un générateur électrique à récupération d'énergie mécanique de vibration, de type bistable ;
la figure 3 est une vue de côté représentant de façon schématique un mode de réalisation d'un générateur électrique à récupération d'énergie mécanique de vibration ;
la figure 4 est une vue de côté représentant de façon schématique un autre mode de réalisation d'un générateur électrique à récupération d'énergie mécanique de vibration ; et
la figure 5 est une vue en perspective représentant de façon schématique un autre mode de réalisation d'un générateur électrique à récupération d'énergie mécanique de vibration.

### Description détaillée

Par souci de clarté, de mêmes éléments ont été désignés par de mêmes références aux différentes figures et, de plus, les diverses figures ne sont pas tracées à l'échelle.

La figure 3 est une vue de côté représentant de façon schématique un mode de réalisation d'un générateur électrique 21 à récupération d'énergie mécanique de vibration.

Le générateur 21 comprend un boîtier de support et de protection 23, par exemple de forme générale parallélépipédique, adapté à être monté sur une surface vibrante. Dans cet exemple, les vibrations extérieures sont susceptibles d'exercer, sur le boîtier 23, une excitation F_{EXT} sensiblement orthogonale à la face inférieure du boîtier.

Le boîtier 23 contient un système oscillant monostable comprenant une lame ressort en forme d'anneau 25, et une masse 27. L'anneau 25 est fixé, en un point, à une face du boîtier 23, ici la face inférieure. La masse 27 est fixée à l'anneau 25 en un point de l'anneau sensiblement opposé au point de fixation de l'anneau au boîtier. Ainsi, le point de fixation de l'anneau au boîtier et le point de fixation de la masse à l'anneau définissent une ligne sensiblement parallèle à l'orientation F_{EXT} de l'excitation extérieure. Plus généralement, on veillera à ce que cette ligne soit non orthogonale à l'orientation F_{EXT} des vibrations extérieures.

Sous l'effet des vibrations mécaniques extérieures, l'anneau 25 et la masse 27 oscillent de bas en haut autour d'une position d'équilibre. Sur la figure, une position basse est illustrée par des traits en pointillés.

Le système comprend en outre un système bistable, couplé au système monostable, comprenant une lame ressort 29 en compression entre ses deux extrémités. Dans cet exemple, les extrémités de la lame 29 s'appuient contre deux points opposés de l'anneau 25, et ces deux points d'appui définissent une ligne sensiblement orthogonale à l'orientation F_{EXT} des vibrations extérieures. Plus généralement, on veillera à ce que les points d'appui de la lame 29 sur l'anneau 25 définissent une ligne non parallèle à l'orientation F_{EXT} des vibrations. L'anneau 25 exerce sur la lame 29 une force de compression F_{COMP}, maintenant la lame 29 en compression entre ses deux extrémités. Une masse 31 est fixée à la lame 29, sensiblement en son milieu dans cet exemple.

La lame 29 et la masse 31, définissent un système bistable du type décrit en relation avec la figure 2. Ce système peut, sous l'effet des vibrations extérieures, passer de l'une à l'autre de deux positions d'équilibre, et/ou osciller autour de chacune des deux positions d'équilibre.

Dans le générateur 21, le système bistable est couplé au système oscillant monostable de telle façon que la valeur de la force F_{COMP}, qui maintient en compression la lame 29 du système bistable, varie de façon périodique, sensiblement à la fréquence de résonance du système monostable. En effet, lorsque le système monostable oscille, les points de fixation de la lame 29 à l'anneau 25 tendent à s'éloigner l'un de l'autre, puis à se rapprocher, induisant une diminution, puis une augmentation de la force exercée sur les extrémités de la lame 29.

Lorsque la force de compression F_{COMP} varie, le niveau minimal d'énergie de vibration nécessaire pour déclencher le passage du système bistable d'une position d'équilibre à l'autre varie en conséquence.

L'inventeur a constaté que, lorsque la force de compression F_{COMP} varie périodiquement, le niveau minimal d'excitation extérieure nécessaire pour provoquer un nombre donné de sauts de position du système bistable dans un intervalle de temps donné diminue de façon significative par rapport à un système bistable classique dans lequel F_{COMP} est constante (à valeurs moyennes de F_{COMP} équivalentes).

Un avantage du dispositif proposé réside dans le fait que c'est l'énergie mécanique des vibrations extérieures elle-même qui permet de faire varier de façon périodique la force F_{COMP}. Ainsi, il n'est pas nécessaire de prévoir un actionneur externe muni d'une alimentation dédiée.

Un convertisseur mécano-électrique, non représenté, est prévu pour convertir le mouvement de la lame 29 et/ou de la masse 31 en énergie électrique. Il peut s'agir d'un convertisseur de type piézoélectrique, par exemple des éléments piézoélectriques placés sur la lame 29, vers ses extrémités, adaptés à subir les déformations de la lame lors du passage de l'une à l'autre des positions d'équilibre, et lors des oscillations linéaires autour de l'une ou l'autre des positions d'équilibre. Il peut également s'agir d'un convertisseur de type électromagnétique ou électrostatique.

A titre d'exemple, l'anneau 25 peut être formé à partir d'un ruban d'acier de largeur de l'ordre de 5 à 50 mm, par exemple de l'ordre de 20 mm, et d'épaisseur de l'ordre de 100 à 500 µm, par exemple de l'ordre de 200 µm. L'anneau peut être, au repos, sensiblement circulaire et avoir un diamètre de l'ordre de 50 à 100 mm, par exemple de l'ordre de 70 mm. La masse 27 peut avoir un poids de l'ordre de 5 à 25 g, par exemple de l'ordre de 10 g. La lame 29 du système bistable peut être formée à partir d'un ruban d'acier de largeur de l'ordre de 5 à 50 mm, par exemple de l'ordre de 20 mm, et d'épaisseur de l'ordre de 50 à 250 µm, par exemple de l'ordre de 75 µm. La masse 31 peut avoir un poids de l'ordre de 2 à 15 g, par exemple de l'ordre de 5 g. Les masses 27 et 31 peuvent être fixées, respectivement à la lame 31 et à l'anneau 25, par collage. Bien entendu, ces dimensions ne sont données qu'à titre d'exemple. En pratique, les dimensions du système peuvent être comprises entre quelques dixièmes de mm et quelques dizaines de cm.

Selon une variante de réalisation, non représentée, on prévoit de disposer, en appui contre les parois de l'anneau 25, plusieurs systèmes bistables tels que celui formé par la lame 29 et la masse 31.

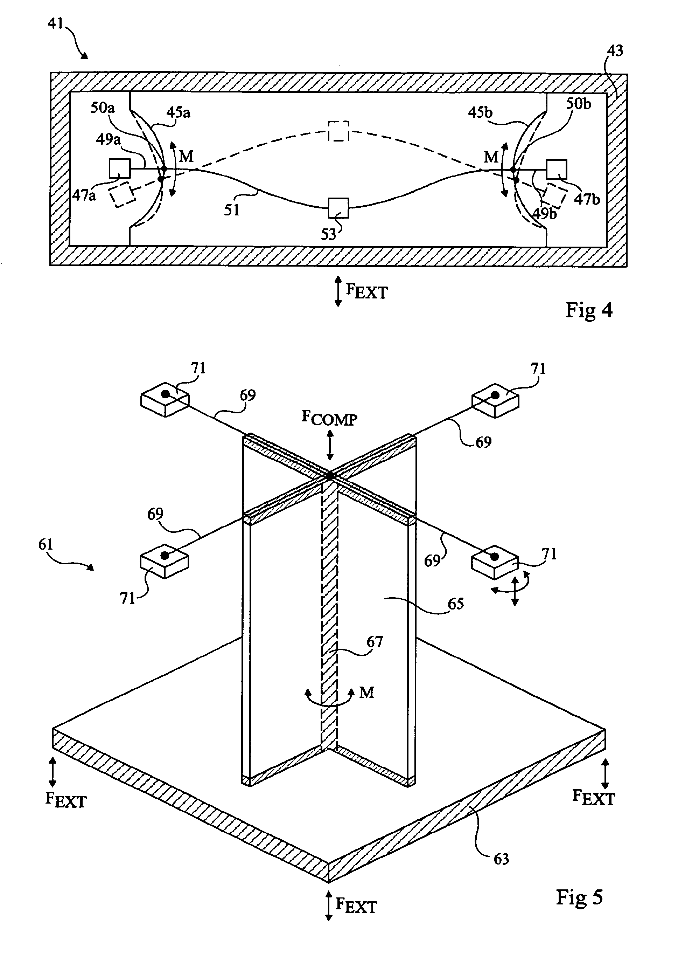

La figure 4 est une vue de côté représentant de façon schématique un autre mode de réalisation d'un générateur électrique 41 à récupération d'énergie mécanique de vibration.

Comme le générateur 21 de la figure 3, le générateur 41 comprend un boîtier de support rigide 43 susceptible d'être excité par des vibrations extérieures d'orientation F_{EXT}, orthogonale à la face inférieure du boîtier.

Le boîtier 43 contient un double système oscillant monostable comprenant deux lames ressort 45a et 45b, ayant chacune la forme d'un arc. Les lames 45a et 45b sont disposées en regard l'une de l'autre. Chaque lame a l'une de ses extrémités fixée à la face supérieure du boîtier, et l'autre extrémité fixée à la face inférieure du boîtier. Dans cet exemple, les points de fixation de chaque lame au boîtier définissent une ligne sensiblement parallèle à l'orientation F_{EXT} des vibrations extérieures. Des masses 47a et 47b sont fixées respectivement aux lames 45a et 45b, par l'intermédiaire de liaisons rigides 49a et 49b. Dans cet exemple, les liaisons rigides 49a et 49b sont orthogonales à l'orientation F_{EXT} des vibrations extérieures, et sont reliées aux lames 45a et 45b en leurs milieux 50a et 50b.

Sous l'effet des vibrations mécaniques extérieures, les lames ressort 45a et 45b se déforment, et les masses 47a et 47b oscillent autour d'une position d'équilibre, ce qui entraîne une oscillation en rotation des points 50a et 50b, autour d'un axe sensiblement orthogonal au plan de la figure 4, ainsi qu'une oscillation sensiblement verticale des points 50a et 50b. Le mouvement des oscillations est illustré par des traits en pointillés sur la figure. Les lames ressort 45a et 45b, associées aux masses 47a et 47b, par l'intermédiaire des liaisons rigides 49a et 49b, forment un double système monostable.

Le boîtier 43 contient en outre un système bistable comprenant une lame ressort 51, dont les extrémités sont fixées respectivement aux lames 45a et 45b, de préférence aux points 50a et 50b. L'écartement entre les lames 45a et 45b est tel que la lame 51 est maintenue en compression entre ses deux extrémités. Une masse 53 est fixée à la lame 51, par exemple en son milieu.

Lorsque le double système monostable oscille, l'action de la déformation des lames 45a et 45b sur chaque extrémité de la lame 51 du système bistable peut être modélisée par un moment M. Le moment M varie de façon périodique, sensiblement à la fréquence de résonance du système monostable.

Lorsque le moment M varie, le niveau minimal d'énergie de vibration nécessaire pour déclencher le passage du système bistable d'une position d'équilibre à l'autre varie simultanément. Ainsi, comme pour le générateur 21 de la figure 3, le niveau minimal d'excitation extérieure nécessaire pour provoquer des sauts de position du système bistable, est nettement plus faible que pour un système bistable classique. De même, pour un niveau d'excitation extérieure donné, le nombre de sauts de position dans un intervalle de temps donné pourra être plus important que pour un système bistable classique.

Un convertisseur mécano-électrique, non représenté, est prévu pour convertir le mouvement de la lame 51 et/ou de la masse 53 en énergie électrique.

A titre de variante, on pourra prévoir un générateur électrique similaire au générateur 41 de la figure 4, mais ne comportant qu'un simple système monostable agissant sur une seule des extrémités de la lame 51, l'autre extrémité étant reliée à un point fixe.

La figure 5 est une vue en perspective représentant de façon schématique un autre mode de réalisation d'un générateur électrique 61 à récupération d'énergie mécanique de vibration.

Le générateur 61 comprend un boîtier de support 63 susceptible d'être excité par des vibrations extérieures d'orientation F_{EXT}, orthogonale à la face inférieure du boîtier. Pour plus de clarté, seule la face inférieure du boîtier 63 est représentée sur la figure.

Le boîtier 63 contient une poutre à section cruciforme 65. La poutre 65 est fixée, par l'une de ses extrémités, à une face du boîtier 63, ici la face inférieure, de façon que la poutre soit sensiblement parallèle à l'orientation F_{EXT} des vibrations extérieures. Dans cet exemple, la poutre 65 est une poutre à section cruciforme, toutefois, l'invention ne se limite pas à ce cas particulier et il pourra s'agir d'une poutre à section en étoile à tout autre nombre de branches (supérieur ou égal à trois).

Un système à ressort, représenté par des traits hachurés, est prévu pour maintenir la poutre en compression entre ses extrémités. Dans cet exemple, il s'agit d'une âme centrale élastique 67 (ou ressort précontraint) qui traverse la poutre de part en part dans sa longueur, cette âme centrale étant reliée, en tension, aux extrémités inférieure et supérieure de la poutre.

La poutre 65 subit, entre ses extrémités, une force de compression F_{COMP} sensiblement verticale, résultant de la tension du ressort 67. Le ressort 67 est choisi tel que la force F_{COMP} soit suffisamment importante pour entrainer le flambage (non représenté) de la poutre selon l'un ou l'autre de deux sens de rotation opposés (autour de l'axe central de la poutre).

Il résulte de ce flambage que la poutre 65 subit, entre ses extrémités, en plus de la force de compression F_{COMP}, une force de torsion, cette force de torsion pouvant être modélisée par un moment M autour d'un axe sensiblement parallèle à l'axe central de la poutre.

De plus, un système de masses 71 est relié à l'extrémité libre de la poutre (ici l'extrémité supérieure). Dans ce mode de réalisation, du côté de l'extrémité supérieure de la poutre, à chaque branche de la poutre est fixé un bras rigide 69, s'étendant selon une direction orthogonale à l'axe central de la poutre, en prolongement de la branche à laquelle il est fixé. Au bout de chaque bras 69, vers l'extérieur de la poutre, est fixée une masse 71.

La poutre 65, en compression et en torsion entre ses extrémités, constitue un système bistable capable de passer, sous l'effet d'une excitation extérieure, de l'une à l'autre de deux positions stables, les deux positions stables correspondant au flambage de la poutre selon l'un et l'autre des deux sens de rotations. En particulier, la poutre 65 est susceptible de passer de l'une à l'autre des deux positions de flambage sous l'effet d'une excitation en rotation de ses extrémités.

De plus, le ressort 67, et le système de masses 71, solidaire de l'extrémité supérieure du ressort 67, définissent un système oscillant monostable. Sous l'effet des vibrations mécaniques extérieures, les masses 71 oscillent de bas en haut autour d'une position d'équilibre. Pendant ces oscillations, la torsion (flambage) de la poutre 65 varie autour de l'une des positions de flambage de la poutre. Les masses 71 étant déportées par rapport à l'axe central de la poutre, les oscillations linéaires en torsion de la poutre 65 entrainent un mouvement de rotation des masses 71, autour de l'axe central de la poutre. Ainsi, les oscillations des masses 71 entraînent une variation périodique de la force de compression F_{COMP}, et du moment de torsion M, auxquels sont soumises les extrémités de la poutre 65.

Il en résulte, comme pour les modes de réalisation décrits en relation avec les figures 3 et 4, une diminution significative du niveau minimal d'énergie de vibration nécessaire pour déclencher le passage de l'une à l'autre des positions d'équilibre du système bistable. De même, pour déclencher un nombre donné de sauts de position dans un intervalle de temps donné, le niveau d'énergie de vibration requis est plus faible que pour un système bistable classique.

Un convertisseur mécano-électrique, non représenté, est prévu pour convertir les mouvements de rotation de la poutre et les déformations des branches en énergie électrique.

Un avantage des générateurs électriques à récupération d'énergie de vibration proposés est qu'ils présentent un rendement supérieur à celui des générateurs actuels.

Un autre avantage des générateurs électriques à récupération d'énergie de vibration proposés est qu'ils exploitent une large plage de fréquences de vibration. De plus, leur rendement reste important, même lorsque le niveau d'énergie de vibration est faible.

On a décrit ci-dessus divers modes de réalisation d'un générateur électrique à récupération d'énergie de vibration. De façon plus générale, un aspect de la présente invention est de prévoir un générateur électrique à récupération d'énergie mécanique de vibration, comprenant un système bistable susceptible de prendre l'une ou l'autre de deux positions stables en réponse à une excitation donnée, et un système oscillant monostable, susceptible d'agir de façon périodique sur le système bistable, sous l'effet de cette même excitation, pour faire varier le niveau d'énergie de vibration nécessaire pour déclencher le passage du système bistable de l'une à l'autre de ses positions d'équilibre.

Des modes de réalisation particuliers de la présente invention ont été décrits. Diverses variantes et modifications apparaîtront à l'homme de l'art.

En particulier, dans chacun des modes de réalisation décrits ci-dessus, la structure oscillante est fixée au boîtier de support et de protection en un ou plusieurs points d'attache. L'homme de l'art saura prévoir des variantes de réalisation dans lesquelles le nombre et la position des points d'attache diffèrent des exemples présentés ci-dessus.

De plus, l'invention ne se restreint pas à une géométrie parallélépipédique du boîtier du générateur, tel que mentionné ci-dessus.

## Revendications

1. Générateur électrique (21 ; 41 ; 61) à récupération d'énergie mécanique de vibration, comprenant :
un système bistable susceptible de prendre l'une ou l'autre de deux positions stables par rapport à deux extrémités, en réponse à une excitation d'une orientation donnée (F_{EXT}) ;
**caractérisé par** au moins un système oscillant monostable susceptible d'agir de façon périodique sur une au moins des deux extrémités, en réponse à ladite excitation ; et
un convertisseur du mouvement d'un élément du système bistable en énergie électrique.

2. Générateur (21) selon la revendication 1, dans lequel :
le système oscillant monostable comprend : une première lame ressort en anneau (25), fixée en un premier point à un support (23) ; et une première masse (27), fixée à la première lame (25) en un second point de l'anneau opposé au premier point, l'axe formé par les premier et second points étant non-orthogonal à ladite orientation (F_{EXT}) ; et
le système bistable comprend : une seconde lame ressort (29), en compression entre deux points de l'anneau (25) formant lesdites extrémités, lesdites extrémités appartenant à une corde de l'anneau non-parallèle à ladite orientation (F_{EXT}) ; et une seconde masse (31) fixée à la seconde lame (29).

3. Générateur selon la revendication 2, dans lequel ledit convertisseur comprend au moins un élément piézoélectrique disposé sur la seconde lame (29).

4. Générateur selon la revendication 2 ou 3, comprenant une pluralité de systèmes bistables disposés de façon que le système monostable soit susceptible d'agir simultanément sur chacun des systèmes bistables.

5. Générateur (41) selon la revendication 1, dans lequel :
le système oscillant monostable comprend : des première (45a) et deuxième (45b) lames ressort en arc, en regard l'une de l'autre, chaque lame étant fixée par ses extrémités à un boîtier de support rigide (43), les points de fixation de chaque lame étant disposés selon une ligne non orthogonale à ladite orientation (F_{EXT}) ; et des première (47a) et deuxième (47b) masses, chaque masse étant fixée à un point intermédiaire de l'une des lames via une liaison rigide (49a, 49b) non parallèle à ladite orientation (F_{EXT}) ; et
le système bistable comprend : une troisième lame ressort (51) en compression entre les première (45a) et deuxième (45b) lames, les points d'appui de la troisième lame (51) sur les première (45a) et seconde (45b) lames formant lesdites extrémités, ces points d'appui étant disposés selon une ligne non parallèle à ladite orientation (F_{EXT}) ; et une troisième masse (53), fixée à la troisième lame (51).

6. Générateur selon la revendication 5, dans lequel ledit convertisseur comprend au moins un élément piézoélectrique disposé sur ladite troisième lame (51).

7. Générateur (61) selon la revendication 1, dans lequel :
le système bistable comprend : une poutre (65) à section cruciforme dont les terminaisons forment lesdites extrémités, la poutre étant fixée à un support (63) par une première terminaison, et étant disposée parallèlement à ladite orientation (F_{EXT}) ; et un système à ressort (67) pour maintenir la poutre en compression entre ses terminaisons de façon qu'elle soit susceptible de prendre l'une ou l'autre de deux positions stables correspondant à la déformation de la poutre par flambage selon l'un ou l'autre de deux sens de rotation opposés ; et
le système oscillant monostable comprend, du côté d'une seconde terminaison de la poutre, au moins une masse (71) susceptible d'agir sur le système à ressort (67), en réponse à ladite excitation.

8. Générateur selon la revendication 7, dans lequel le système à ressort comprend une âme élastique (67) traversant la poutre (65) de part en part dans sa longueur, cette âme étant fixée, en tension, à chacune des terminaisons de la poutre.

9. Générateur selon la revendication 7 ou 8, dans lequel ladite au moins une masse (71) est reliée à la seconde terminaison de la poutre (65) par l'intermédiaire d'un bras rigide (69) orthogonal à ladite orientation (F_{EXT}).

10. Générateur selon l'une quelconque des revendications 7 à 9, dans lequel le convertisseur comprend au moins un élément piézoélectrique disposé sur la poutre (65).

## Patentansprüche

1. Elektrischer Generator (21; 41; 61) mit Energierückgewinnung aus mechanischer Vibration, der folgendes aufweist:
ein bistabiles System, welches in der Lage ist die eine oder die andere von zwei stabilen Positionen bezüglich zwei Enden einzunehmen, und zwar ansprechend auf eine Erregung mit gegebener Orientierung (F_{EXT}),
mindestens ein monostabiles Oszillationssystem, welches in der Lage ist, periodisch auf mindestens eines der zwei Enden einzuwirken, und zwar ansprechend auf die erwähnte Erregung; und
einen Umwandler, der Bewegung eines Elementes des bistabilen Systems in elektrische Energie.

2. Der Generator (21) nach Anspruch 1, wobei:
das monostabile Oszillationssystem folgendes aufweist: eine erste ringförmige Federklinge (25) angebracht an einem ersten Punkt eines Trägers (23); und
eine erste Masse (27) angebracht an der ersten Klinge (25) an einem zweiten Punkt des Rings entgegengesetzt zum ersten Punkt, wobei die durch die ersten und zweiten Punkte geformte Achse nicht orthogonal zu der erwähnten Orientierung (F_{EXT}) verläuft; und
wobei das bistabile System folgendes aufweist: eine zweite Federklinge (29) in Kompression zwischen zwei Punkten des Ringes (25), die die erwähnten Enden bilden, wobei die erwähnten Enden zu einem Teil (chord) des Rings gehören, der nicht parallel zu der erwähnten Orientierung (F_{EXT}) verläuft; und
wobei eine zweite Masse (31) an der zweiten Klinge (29) angebracht ist.

3. Der Generator nach Anspruch 2, wobei der Wandler mindestens ein piezoelektrisches Element aufweist, und zwar angeordnet auf der zweiten Klinge (29).

4. Der Generator nach Anspruch 2 oder 3, der folgendes aufweist:
eine Vielzahl von bistabilen Systemen angeordnet derart, dass das monostabile System in der Lage ist, gleichzeitig auf jedes der bistabilen Systeme einzuwirken.

5. Der Generator (41) nach Anspruch 1, wobei das monostabile Oszillationssystem folgendes aufweist: erste (45a) und zweite (45b) bogenförmige voreinander angeordnete Klingen, wobei jede Klinge durch ihre Enden an einer starren Tragpackung (43) angebracht ist, wobei der Anbringungspunkt jeder Klinge entlang einer Linie angeordnet ist, die nicht orthogonal zu der erwähnten Orientierung (F_{EXT}) verläuft; und wobei ferner erste (47a) und zweite (47b) Massen vorgesehen sind, und jede Masse an einem Zwischenpunkt einer der Klingen angebracht ist, und zwar über eine starre Verbindung (49a, 49b), die nicht parallel zu der erwähnten Orientierung (F_{EXT}) verläuft; und
wobei das bistabile System folgendes aufweist: eine dritte Federklinge (51) in Kompression zwischen der ersten Klinge (45a) und der zweiten Klinge (45b), wobei die Lagerpunkte der dritten Klinge (51) auf der ersten Klinge (45a) und der zweiten Klinge (45b), die die erwähnten Enden bilden, angeordnet sind, derart, dass diese Lagerpunkte entlang einer Linie angeordnet sind, die nicht parallel zu der Orientierung (F_{EXT}) verläuft und wobei eine dritte Masse (53) an der dritten Klinge (51) angebracht ist.

6. Der Generator nach Anspruch 5, wobei der Wandler mindestens ein piezoelektrisches Element aufweist, angeordnet auf der dritten Klinge (51).

7. Generator (61) nach Anspruch 1, wobei folgendes vorgesehen ist:
das bistabile System weist folgendes auf: einen Arm (65) mit einem kreuzförmigen Querschnitt mit Abschlüssen, die die erwähnten Enden formen, wobei der Arm an einem Träger (63) angebracht ist, und zwar durch einen ersten Abschluss, und zwar angeordnet parallel zu der erwähnten Orientierung (F_{EXT}); und eine Federsystem (67), um den Arm in Kompression zwischen seinen Abschlüssen derart zu halten, dass er in der Lage ist, eine oder die andere der zwei stabilen Positionen entsprechend der Deformation des Arms einzunehmen, und zwar durch Biegen gemäß einer oder der anderen von zwei entgegengesetzten Drehrichtungen; und
wobei das monostabile Oszillationssystem auf der Seite eines zweiten Abschlusses des Trägers mindestens eine Masse (71) aufweist, die in der Lage ist ansprechend auf die erwähnte Erregung auf das Federsystem (67) einzuwirken.

8. Der Generator nach Anspruch 7, wobei das Federsystem einen elastischen Kern (67) aufweist, der den Arm (65) in Längsrichtung vollständig kreuzt, wobei dieser Kern unter Spannung an jedem der Armabschlüsse angebracht ist.

9. Der Generator nach Anspruch 7 oder 8, wobei die erwähnte mindestens eine Masse (71) mit dem zweiten Abschluss des Arms (65) verbunden ist, und zwar über einen starren Arm (69) senkrecht zu der Orientierung (F_{EXT}).

10. Der Generator nach irgendeinem der Ansprüche 7 bis 9, wobei der Wandler mindestens ein piezoelektrisches Element aufweist, und zwar angeordnet auf dem Arm (65).

## Claims

1. A mechanical vibration energy recovery electric generator (21; 41; 61), comprising:
a bistable system capable of taking one or the other of two stable positions with respect to two ends, as a response to an excitation of given orientation (F_{EXT});
at least one monostable oscillating system capable of periodically acting on at least one of the two ends, as a response to said excitation; and
a converter of the motion of an element of the bistable system into electric energy.

2. The generator (21) of claim 1, wherein:
the monostable oscillating circuit comprises: a first ring-shaped spring blade (25), attached at a first point to a support (23); and a first mass (27), attached to the first blade (25) at a second point of the ring opposite to the first point, the axis formed by the first and second points being non orthogonal to said orientation (F_{EXT}); and
the bistable system comprises: a second spring blade (29), in compression between two points of the ring (25) forming said ends, said ends belonging to a chord of the ring which is not parallel to said orientation (F_{EXT}); and a second mass (31) attached to the second blade (29).

3. The generator of claim 2, wherein said converter comprises at least one piezoelectric element arranged on the second blade (29).

4. The generator of claim 2 or 3, comprising a plurality of bistable systems arranged so that the monostable system is capable of simultaneously acting on each of the bistable systems.

5. The generator (41) of claim 1, wherein:
the monostable oscillating circuit comprises: first (45a) and second (45b) arc-shaped blades, in front of each other, each blade being attached by its ends to a rigid support package (43), the point of attachment of each blade being arranged along a line which is not orthogonal to said orientation (F_{EXT}); and first (47a) and second (47b) masses, each mass being attached to an intermediate point of one of the blades via a rigid connection (49a, 49b) which is not parallel to said orientation (F_{EXT}); and
the bistable system comprises: a third spring blade (51) in compression between the first (45a) and second (45b) blades, the bearing points of the third blade (51) on the first (45a) and second (45b) blades forming said ends, such bearing points being arranged along a line which is not parallel to said orientation (F_{EXT}); and a third mass (53), attached to the third blade (51).

6. The generator of claim 5, wherein said converter comprises at least one piezoelectric element arranged on said third blade (51).

7. The generator (61) of claim 1, wherein:
the bistable system comprises: a beam (65) having a cross-shaped section with terminations forming said ends, the beam being attached to a support (63) by a first termination and being arranged parallel to said orientation (F_{EXT}); and a spring (67) system for maintaining the beam in compression between its terminations so that it is capable of taking one or the other of two stable positions corresponding to the deformation of the beam by buckling according to one or the other of two opposite rotation directions; and
the monostable oscillating system comprises, on the side of a second termination of the beam, at least one mass (71) capable of acting on the spring system (67), as a response to said excitation.

8. The generator of claim 7, wherein the spring system comprises a resilient core (67) thoroughly crossing the beam (65) lengthwise, this core being attached, under tension, to each of the beam terminations.

9. The generator of claim 7 or 8, wherein said at least one mass (71) is connected to the second termination of the beam (65) via a rigid arm (69) orthogonal to said orientation (F_{EXT}).

10. The generator of any of claims 7 to 9, wherein the converter comprises at least one piezoelectric element arranged on the beam (65).
